# FASCICULE DE BREVET EUROPEEN

(11) **EP 1 999 302 B1**
(45) Date de publication et mention de la délivrance du brevet: **19.08.2009**
(21) Numéro de dépôt: 07730927.6
(22) Date de dépôt: 06.02.2007
(51) Int. Cl.: C25D 5/02, C25D 17/10, C25F 3/14, C25D 7/12, B81C 1/00

(54) **PROCEDE DE STRUCTURATION ELECTROCHIMIQUE D'UN MATERIAU CONDUCTEUR OU SEMI-CONDUCTEUR, ET DISPOSITIF DE MISE EN OEUVRE**
VERFAHREN ZUR ELEKTROCHEMISCHEN STRUKTURIERUNG EINES LEITER- ODER HALBLEITERMATERIALS UND VORRICHTUNG DAFÜR
METHOD FOR ELECTROCHEMICALLY STRUCTURING A CONDUCTUVE OR SEMICONDUCTOR MATERIAL, AND DEVICE FOR IMPLEMENTING IT

(30) Priorité: 03.03.2006 FR 0601924
(43) Date de publication de la demande: 10.12.2008
(73) Titulaire: COMMISSARIAT A L'ENERGIE ATOMIQUE, 75015 Paris (FR)
(72) Inventeur: BUTTARD, Denis, F-38640 Claix (FR)
(74) Mandataire: Corret, Hélène
(86) Numéro de dépôt international: PCT/FR2007/000211
(87) Numéro de publication internationale: WO 2007/099210

(56) Documents cités:
- WO-A-99/45179
- WO-A-02/103085
- WO-A-20/06010888
- WO-A2-20/04099469
- WO-A2-20/05033798
- US-A1- 2003 111 346

## Description

L'invention se rapporte à un procédé électrochimique de micro et/ou nano-structuration d'un matériau conducteur ou semi-conducteur, notamment pour la fabrication de composants élémentaires de la microélectronique, ainsi qu'à un dispositif de mise en oeuvre du procédé.

D'une manière générale, la diminution rapide et régulière de la taille des composants élémentaires de la microélectronique, conduit à la fabrication et à l'étude de nouveaux matériaux aux dimensions micro et nanométriques. Ces matériaux doivent ensuite être intégrés dans des composants, ce qui conduit à la réalisation de dispositifs ayant de très petites dimensions et dont la fabrication doit répondre à des critères tels que la simplicité, la rapidité, la puissance et le faible coût de fabrication.

Pour obtenir ces composants élémentaires, les matériaux utilisés doivent subir un certain nombre d'étapes technologiques élaborées telles que des structurations (gravures et/ou des dépôts) qui se décomposent en deux sous catégories : structuration sèche et structuration en milieu liquide.

La structuration sèche permet, par exemple, de réaliser des structures anisotropes, que le matériau soit cristallin ou amorphe, mais elle nécessite un matériel cher et de haute technologie induisant, entre autres, des défauts dans l'état de surface des échantillons.

En revanche la structuration en milieu liquide est simple à mettre en oeuvre et représente donc un faible coût de fabrication. Elle se décompose elle-même en deux sous catégories : structuration chimique et structuration électrochimique.

La structuration chimique est la technique la plus simple - elle consiste à tremper l'échantillon muni d'un masque dans différents bains pour obtenir la structure désirée -, mais elle peut être sensible au caractère cristallin du matériau de sorte que les réactions peuvent ne pas être identiques selon que le matériau est amorphe ou cristallin. Dans ce dernier cas, des réactions privilégiées peuvent se produire suivant des directions cristallographiques. En outre, la structuration chimique est uniforme de sorte qu'aucune structuration ne peut être obtenue en l'absence de masque sur chaque échantillon à structurer.

La structuration par voie électrochimique offre l'avantage d'être une technique peu coûteuse avec peu d'étapes technologiques, et de réaliser des réactions anisotropes et relativement indépendantes du caractère cristallin du matériau. La limitation principale des réactions électrochimiques est la prise de contact électrique de l'échantillon à travers lequel on doit faire passer un courant électrique. En outre l'échantillon doit être obligatoirement un matériau conducteur ou semi-conducteur. Il existe de nombreux exemples d'utilisation de l'électrochimie en laboratoire ou dans le secteur industriel : la réduction cathodique permet la réalisation de dépôts métalliques (Mg, Ni, Pd, Fe, Sn, etc.) mais aussi d'alliages (Cu-Sn, Cu-Zn, Ni-Zn, etc.) ; l'oxydation anodique permet l'électropolissage et la gravure, comme par exemple pour l'aluminium où l'on forme une couche de Al₂O₃ qui permet une protection contre la corrosion et une isolation électrique. Dans le cadre des semi-conducteurs, on peut citer l'électrochimie du silicium qui permet de réaliser un électropolissage complet ou partiel du matériau (oxydation anodique) mais aussi diverses électrodépositions (réduction cathodique).

On va donner, ci-après, trois exemples concrets pour la réalisation de micro et/ou nano structures.

Le premier exemple concerne la réalisation d'échantillons de silicium collé-tourné -terme expliqué ci-après- suivie d'une gravure chimique. Dans cet exemple, le collage de deux plaquettes de silicium monocristallin est de type moléculaire et réalisé avec un angle de désorientation, comme décrit par Wallis and D.I. Pomerantz J. Appl. Phys. 40, 3946 (1969), [Wallis et al., 1969], par M. Schimbo, K. Furukawa, K. Fukuda and K. Tanzawa, J. Appl. Phys. 60, 2987 (1986), [Schimbo et al., 1986], et par D. Buttard, J. Eymery, F. Fournel, P. Gentile, F. Leroy, N. Magnéa, H. Moriceau, G. Renaud, F. Rieutord, K. Rousseau, J.L. Rouvière, IEEE, J. Quantum electronics 38, 995-1005 (2002), [Buttard et al., 2002].

Après un recuit, ce collage (sans colle) induit un réseau de dislocations parfaitement localisé dans le plan de l'interface de collage. Ce super-réseau induit un champ périodique de déformation latéral. Si la couche supérieure est suffisamment amincie (exemple 10 nm), ce champ périodique émerge à la surface. La distance entre les dislocations (de quelques nm à 100 nm) est parfaitement maîtrisée par le contrôle de l'angle de rotation introduit entre les deux plaquettes avant collage, comme cela est notamment montré par F. Fournel, H. Moriceau, B. Aspar, K. Rousseau, J. Eymery ; J.L. Rouvière, N. Magnéa, Appl. Phys. Lett. 80, 793 (2002) [F. Fournel et al., 2002]. La gravure chimique ou électrochimique préférentielle de ces lignes de dislocations permet ensuite de réaliser les nanostructures auto-organisées de silicium d'une grande perfection, comme cela est notamment montré (par voie chimique) par F. Leroy, J. Eymery, P. Gentile, F. Fournel, Surface Science 545, 211 (2003), [F. Leroy et al., 2003].

Cependant, la gravure chimique des lignes de dislocations n'atteint des profondeurs que de quelques nm à 10 nm maximum. Au-delà, la surface subit un phénomène de nivellement. De plus, ce procédé est complexe car les étapes technologiques pour le collage moléculaire sont nombreuses et nécessitent une salle blanche. Il est donc très onéreux et difficile à mettre en oeuvre industriellement.

Un deuxième exemple concerne la réalisation de nanofils qui peuvent être obtenus par croissance selon un procédé appelé croissance Vapeur-Liquide-Solide (VLS : vapor-liquid-solid en anglais). Wagner et Ellis Appl. Phys. Lett. 4 (5) 1 March 1964 [Wagner and Ellis 1964] et J. W. Dailey, J. Taraci and T Clement, J. Appl. Phys., 96 (12), 15 December 2004, [J. W. Dailey et al., 2004], ont montrés que ce mode- de- croissance permet de réaliser, via un catalyseur métallique, des fils semi-conducteurs de diamètre inférieur à la centaine de nanomètres et comporte deux étapes : dépôt et structuration d'un catalyseur sur une surface plane, sous forme de nanogouttes. Puis croissance, contrôlée et localisée, des nanofils sous le catalyseur. En choisissant, à titre d'exemple, l'or comme catalyseur et le silicium comme matériau, la méthode VLS consiste à amener la matière sous forme gazeuse, par exemple du silane SiH₄, au niveau de la surface du substrat (semi-conducteur, verre, etc..) sur laquelle a été déposé, au préalable, un catalyseur métallique. Grâce à l'étude du diagramme de phase binaire catalyseur/silicium, l'échantillon est chauffé au-dessus de la température eutectique du mélange, ce qui permet d'obtenir le catalyseur sous forme de gouttes liquides. Cette étape est appelée le démouillage. L'ensemble forme alors un mélange binaire liquide avec le silicium. En apportant en continu le silane gazeux, le mélange binaire en silicium est enrichit jusqu'à saturation. Le silicium précipite et forme alors le fil. Celui-ci croit, de manière cristalline, tant que de la matière est amenée et que le catalyseur est sous forme liquide. La croissance est complexe et fait intervenir de nombreux paramètres :
- la température de recuit est responsable du démouillage du catalyseur, ce recuit assurant également une surface propre en éliminant toutes poussières et autre couche d'oxyde qui aurait pu se former avant la croissance ;
- le diamètre de la goutte du catalyseur définit le diamètre du fil ;
- la température de croissance (supérieure à la température eutectique) contrôle la forme et la qualité du fil ;
- le temps de croissance est responsable de la longueur des nanofils ;
- le flux de silane (SiH₄) mélangé à de l'hydrogène gazeux règle également la longueur des fils ; et
- le tout ayant lieu en salle blanche avec de nombreux problèmes technologiques, sachant par ailleurs que le catalyseur le plus couramment utilisé est l'or qui est incompatible avec la microélectronique en raison de ses propriétés diffusantes.

Cette méthode par croissance nécessite une installation importante présentant une mise en oeuvre complexe et coûteuse.

Une autre méthode de réalisation de nanofils est la lithographie nano-impression, décrite par T. Martensson, P. Carlberg, M. Borgström, L. Montelius, W. Seifert, L. Samuelson, Nanoletters 4, 699 (2004), [T. Martensson et al., 2004]. Bien que d'un plus faible coût que les lithographies traditionnelles, cette méthode nécessite encore de nombreux moyens de microélectronique. Par ailleurs les fils obtenus ne peuvent être de diamètre inférieur à 300 nm.

Enfin, le troisième exemple concerne la réalisation de silicium poreux par voie électrochimique, décrite, notamment, dans les articles de A. Ulhir, Bell System Tech. J. 35 333 (1956), [A. Ulhir et al., 1956], de D.R. Tumer, J. Electrochem. Soc. 105, 402 (1958), [D.R. Tumer et al., 1958], et de G. Cullis, L. T. Canham, P. D. J. Calcott, J. Appl. Phys. 82, 909 (1997), [G. Cullis et al., 1997].

Dans des conditions particulières de réactions (err adaptant les paramètres tels que la densité de courant; la concentration en acide fluorhydrique ou le temps d'anodisation), l'électropolissage du silicium devient partiel ce qui permet d'obtenir une structure poreuse nanométrique cristalline. Suivant la nature et le niveau de dopage du substrat d'origine, différentes structures nano et/ou microporeuses sont obtenues. Par exemple le diamètre des pores et des cristallites est de l'ordre de 2 à 3 nanomètres (nm) à quelques 10 nm pour un substrat dopé p. Le silicium poreux a été largement étudié ces dernières années, notamment pour ses propriétés de luminescence mais aussi pour son caractère cristallin et fortement poreux - des porosités pouvant aller jusqu'à 90%.

Des procédés parallèles ont été utilisés comme, par exemple, la réalisation par T. Nakagawa, H. Sugiyama, N. Koshida, Jpn J. Appl. Phys. 37, 7186 (1998), [T. Nakagawa et al., 1998], de structures périodiques en fabriquant du silicium poreux sous champ magnétique ou la réalisation par G. Lerondel, R. Romestain, J.C. Vial, M. Thônissen Appl. Phys. Lett. 71, 196 (1997), [G. Lerondel et al., 1997], de super réseaux latéraux par interférences d'ondes lumineuses.

Cependant, dans tous les cas, la structure poreuse du silicium poreux est désordonnée et ne présente aucune périodicité. En particulier les points initiaux de gravures ont lieu sur des défauts et ne sont donc pas contrôlés en position. Pour les dispositifs à base de silicium poreux les structures réalisées sont en générale « assez grosses » (quelques µm pour les méthodes optiques, et quelques centaines de nm pour les autres méthodes). En outre, ces méthodes nécessitent un grand nombre d'étapes technologiques.

Par ailleurs, le document de brevet WO 9945179 décrit une cellule d'électrochimie dans laquelle est plongée le matériau à graver en contact électrique direct avec le circuit électrique. Une électrode munie d'un masque ajouré de gravure est placée au voisinage du matériau mais pas en contact. Le masque ajouré utilisé est isolant, c'est-à-dire que les parties de l'électrode qui sont recouvertes par le masque ne transmettent pas le courant, alors que les parties de l'électrode non recouvertes, situées en face des jours du masque, transmettent le courant. La transmission du courant se fait donc à travers le masque, puis à travers l'électrolyte afin de provoquer la réaction chimique voulue sur la surface, distante, du matériau à graver. Le matériau est recouvert d'une couche protectrice destinée à empêcher le matériau d'être attaqué par l'électrolyte. Lorsque le courant passe, la couche protectrice située en face des jours du masque est dissoute et l'électrolyte creuse le matériau. L'inconvénient de cette méthode réside dans la sensibilité du matériau à l'électrolyte qui oblige à une grande vigilance lorsque la réaction chimique de dissolution de la couche protectrice a commencé pour s'assurer que la gravure, d'une part, est suffisante et, d'autre part, n'est pas trop profonde. De plus, la réaction se faisant à distance dans l'électrolyte, la réaction chimique peut, légèrement et aléatoirement, déborder sur la surface située sous le masque isolant, de sorte que la gravure n'est ni précise, ni reproductible. Enfin, aucun dépôt n'est possible puisque seule l'attaque du matériau est réalisée par l'électrolyte.

Le document de brevet WO 02103085 résout le problème précédent en proposant de plaquer l'électrode munie d'un masque ajouré isolant contre la surface du matériau à structurer. De l'électrolyte est ainsi enfermé entre les reliefs isolants du masque, l'électrode et le matériau à structurer. Suivant le branchement de l'électrode et du matériau, dépôts et gravures peuvent être réalisés. Ici encore, le courant passe à travers le masque puis à travers l'électrolyte afin de provoquer la réaction chimique voulue sur la surface du matériau à structurer. Cependant, lors de la réaction chimique, l'électrolyte s'appauvrit ou s'enrichit de sorte qu'il est nécessaire de prévoir un système de drainage de l'électrolyte pour maîtriser la réaction. Un tel système est coûteux, délicat à mettre en oeuvre - et voire parfois impossible pour certains motifs à réaliser.

Enfin, le document de brevet WO 2004099469 propose, contrairement aux documents précédents, de réaliser une micro ou nano structuration d'un échantillon à l'aide d'une électrode muni d'un masque de gravure conducteur. Cette électrode est constituée d'une plaque sur laquelle ont été déposés des nano reliefs conducteurs. L'espace situé entre ces nano reliefs ne conduit pas le courant et peut être rempli de matériau isolant. L'électrode est placée au voisinage, mais non au contact, du matériau à graver, lui-même relié électriquement directement au circuit électrique. Le courant passe donc par le masque et à travers l'électrolyte afin de provoquer la réaction chimique voulue sur la surface du matériau à structurer. L'inconvénient d'un tel dispositif réside dans la nécessité d'adapter systématiquement la distance de l'électrode structurée par rapport au matériau pour permettre la croissance en hauteur ou la gravure en profondeur de nanostructures sur la surface du matériau. Cette variation de distance peut entraîner un léger décalage latéral de l'électrode et rendre la structuration imprécise et légèrement aléatoire.

Sur la base de cet état de la technique, l'objectif de la présente invention est donc de proposer un nouveau procédé de structuration électrochimique fiable, rapide, simple, facile à mettre en oeuvre et hautement reproductible qui est basé sur l'utilisation d'une électrode électriquement reliée à un masque de gravure conducteur plaqué en contact ohmique sec contre une face arrière d'un échantillon de matériau conducteur ou semi conducteur, et de placer la partie à graver de ce matériau dans un électrolyte au voisinage d'une électrode.

L'invention a donc pour objet un procédé de micro et/ou nano-structuration électrochimique d'un échantillon de matériau conducteur ou semi-conducteur et comprenant deux faces opposées, une face avant et une face arrière, **caractérisé en ce qu**'il comprend les étapes consistant à :
(a) mettre au moins la face avant de l'échantillon en contact avec au moins une solution électrolytique stockée dans au moins un réservoir ;
(b) disposer au moins une contre-électrode dans l'électrolyte en regard de la face avant de l'échantillon qui doit être structurée ;
(c) disposer au moins une électrode de travail en contact ohmique sec avec la face arrière de l'échantillon et présentant des motifs de structuration ; et
(d) appliquer un courant électrique entre au moins une contre électrode et une électrode de travail qui sont sensiblement en regard l'une de l'autre pour obtenir une réaction électrochimique à l'interface de la face avant de l'échantillon et de l'électrolyte avec une densité de courant qui est modulée par les motifs de structuration de l'électrode de travail pour former une gravure et/ou un dépôt sur la face avant de l'échantillon.

Selon des formes de réalisation particulières, en fonction du sens du courant, la réaction électrochimique est soit une réaction d'oxydation conduisant à une gravure de la face avant de l'échantillon, soit une réaction de réduction conduisant à un dépôt sur la face avant de l'échantillon.

La réaction d'oxydation conduisant à une gravure est obtenue en faisant jouer à au moins une contre-électrode le rôle d'une cathode et à- l'électrode de travail sensiblement en regard le rôle d'une anode, et avec une solution électrolytique de préférence acide, l'acide pouvant être de l'acide fluorhydrique, l'acide chlorhydrique, l'acide orthophosphorique, l'acide oxalique, l'acide sulfurique ou l'acide chromique, avec des concentrations variables selon l'acide utilisé conformément aux usages connus de l'Homme du Métier.

La réaction de réduction conduisant à un dépôt est obtenue en faisant jouer à au moins une contre-électrode le rôle d'une anode et à l'électrode de travail, sensiblement en regard, le rôle d'une cathode, et avec une solution électrolytique qui est fonction du matériau à déposer sur la face avant de l'échantillon, comme par exemple une solution de CuSO₄, CoSO₄, FeSO₄, NiSO₄, SnSo₄, ZnSo₄, etc.

L'invention a aussi comme objet un dispositif de micro et/ou nano-structuration électrochimique d'un échantillon en un matériau conducteur ou semi-conducteur et comprenant deux faces opposées, une face avant et une face arrière, pour la mise en oeuvre du procédé précédent, comprenant une cellule d'électrochimie munie d'un réservoir contenant un électrolyte et d'un circuit électrique relié à au moins une contre-électrode et à au moins une électrode de travail, **caractérisé en ce que** au moins une contre-électrode est positionnée en regard de la face avant de l'échantillon, et la face arrière de l'échantillon est mise en contact ohmique sec avec au moins une électrode de travail, celle-ci présentant des motifs de structuration déterminant, le long du contact ohmique, des parties isolantes et des parties conductrices, ces dernières correspondant au motif à graver et/ou déposer sur la face avant de l'échantillon.

Selon des formes de réalisation particulières :
- seule la face avant est en contact avec l'électrolyte, la face arrière étant au sec par rapport à l'électrolyte, et à cet effet, le réservoir présente un fond muni d'une ouverture et la face avant de l'échantillon est plaquée contre l'ouverture avec interposition d'un joint d'étanchéité, par exemple en élastomère fluoré ; ou
- l'échantillon et les électrodes sont situés dans l'électrolyte avec un moyen d'étanchéité agencé pour maintenir les motifs de structuration en contact sec avec la face arrière de l'échantillon.

Selon un premier exemple, dans lequel au moins une électrode de travail comprend d'une tête d'amenée de courant présentant une surface structurée destinée à être mise en contact ohmique avec la face arrière de l'échantillon et comprenant des reliefs conducteurs déterminant le motif à structurer et des évidements isolants, la surface structurée de la tête d'amenée de courant pouvant être obtenue par lithographie couplée à une gravure ionique réactive RIE (« reactive ion etching » en anglais).

Selon un deuxième exemple, au moins une électrode de travail comprend une tête d'amenée de courant en contact ohmique avec un masque amovible présentant des motifs de structuration comprenant des reliefs conducteurs déterminant le motif à structurer et des évidements isolants.

Le masque peut être un échantillon de silicium collé/tourné et gravé pour présenter les reliefs conducteurs déterminant le motif à structurer et les évidements isolants, les évidements peuvent être remplis d'un matériau isolant affleurant les reliefs conducteurs, le matériau isolant pouvant être étanche à l'électrolyte ;

D'une manière générale, le circuit électrique comprend au moins une alimentation constituée par un galvanostat/potentiostat. En mode galvanostatique le système comprend au moins une contre-électrode en platine conformée en disque-grille ou en panier sans fond et la réaction à lieu à courant constant. Une alternative consiste à utiliser le dispositif en mode potentiostatique. Pour cela une troisième électrode appelée « électrode de référence » est ajoutée aux précédentes dans l'électrolyte et permet de maintenir un potentiel constant entre la contre-électrode de platine et l'électrode de travail. Le dispositif comprend en outre un moyen d'agitation de l'électrolyte.

Le procédé et le dispositif de mise en oeuvre permettent notamment de réaliser le dépôt ou la croissance de nano structures telles que des nano fils, de manière simple, rapide, peu coûteuse et répétitive par voie électrochimique.

D'autres caractéristiques de l'invention seront énoncées dans la description détaillée ci-après faite en référence aux figures annexées, données à titre d'exemple, et qui représentent, respectivement :
- la figure 1, une vue en coupe d'un dispositif de structuration électrochimique selon l'invention pour structurer un échantillon placé entre deux électrodes ;
- la figure 2, une vue en perspective d'une contre-électrode conformée en disque-grille ;
- la figure 3, une vue en perspective de la contre-électrode conformée en panier sans fond ;
- la figure 4, une vue en coupe de l'ébauche d'une électrode de travail avant structuration selon l'invention ;
- les figures 5 et 6, des vues en coupe de deux modes de réalisation d'une électrode de travail réalisée à partir de l'électrode de la figure 4 ;
- la figure 7, une vue en coupe de l'électrode de travail de la figure 5 combinée à un matériau isolant ;
- la figue 8, une vue en coupe d'un autre mode de réalisation d'un dispositif de structuration électrochimique selon l'invention ;
- la figure 9, une vue en coupe d'un échantillon de matériau conducteur sur lequel ont été déposées des structures par le procédé selon l'invention ;
- la figure 10, une vue en coupe d'un échantillon de matériau conducteur sur lequel ont été gravées des structures par le procédé selon l'invention ; et
- la figure 11, une vue en coupe d'un dispositif de structuration électrochimique selon l'invention permettant plusieurs types de structuration simultanée sur un même échantillon.

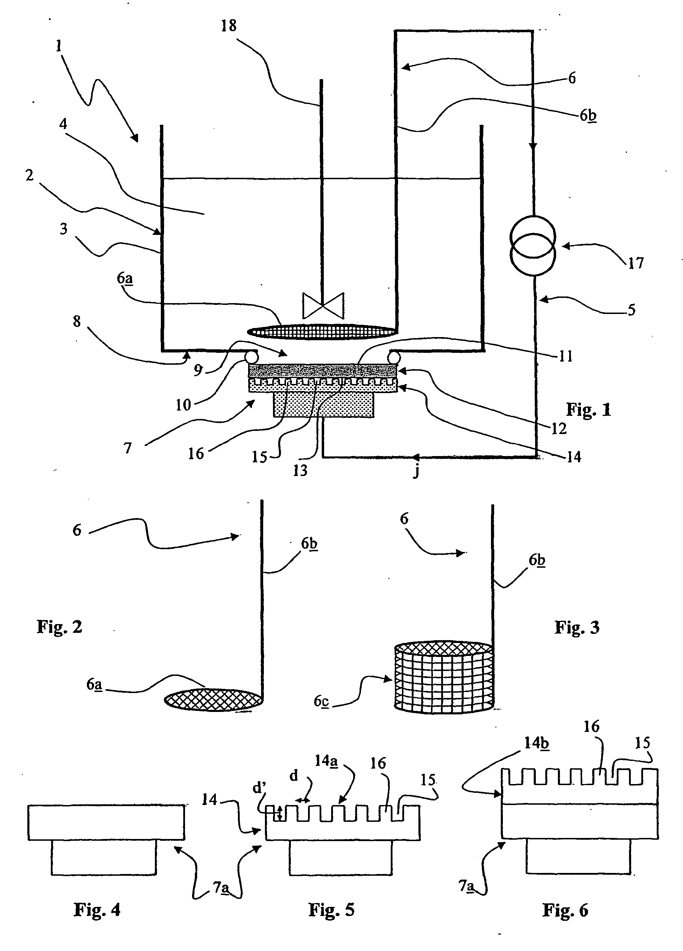

Un premier mode de réalisation d'un dispositif de micro et/ou nano-structuration électrochimique 1 selon l'invention est représenté dans la figure 1, et ce dispositif comprend une cellule d'électrochimie 2 munie d'un réservoir 3, contenant une solution électrolytique 4, et d'un circuit électrique 5 relié à une première 6 et une seconde 7 électrode.

Le réservoir 3 présente un fond 8 muni d'une ouverture 9 - par exemple d'une largeur de 7mm, 10mm, 30mm ou 80mm - et d'un joint d'étanchéité 10 contre lesquels viennent s'appliquer une face avant 11 d'un échantillon 12 de matériau conducteur ou semi conducteur. La face avant 11 de l'échantillon 12 est donc placée contre l'ouverture 9 en contact chimique avec l'électrolyte 4.

Le réservoir 3 peut être en matériau à base de tétrafluoroéthylène, couramment appelé Teflon®, qui est une matière relativement inerte à de nombreuses espèces chimiques. Mais elle présente l'inconvénient de fluer au cours du vieillissement ce qui conduit à des fuites prématurées. Pour cela, le réservoir 3 est préférentiellement constitué en PVC qui présente plus de rigidité tout en résistant également à beaucoup d'espèces chimiques. L'étanchéité entre le matériau 12 et le réservoir 3 est préférentiellement obtenue grâce à un joint en élastomère fluoré tel qu'un joint Viton.

La contre-électrode 6 est positionnée en regard de la face avant 11 de l'échantillon 12 par un moyen de positionnement (non représenté) qui peut être, par exemple, une entretoise ou un bras à réglage micro ou nanométrique. Dans ce montage, la contre-électrode 6 est conformée en un disque-grille 6a en platine (figure 2) plongé dans l'électrolyte 4. A titre d'exemple, le diamètre du disque 6a est de 59 mm, le disque 6a est supporté par une tige 6b de 2 mm de diamètre et de 150 mm de hauteur et les mailles font 0.8 mm de côté et le diamètre des fils de maille est de 0.16 mm.

Pour résoudre le problème de mauvaise répartition des lignes de courant, la contre-électrode 6 doit être la plus proche possible de toute la face avant 11 de l'échantillon 12. Le disque-grille 6a permet non seulement de diminuer la distance entre la contre-électrode 6 et la surface avant à structurer 11, mais elle permet aussi de répartir le courant de façon homogène et rectiligne au voisinage de la face avant 11. Avantageusement on utilise une contre-électrode 6 conformée en panier sans fond (figure 3) munie d'une tige de support 6b et d'un panier maillé sans fond 6c. Le panier sans fond est globalement plus éloigné de la surface de l'échantillon qu'un disque-grille, mais il offre l'avantage de pouvoir placer l'agitateur 18 plus près de la surface, donc de bien homogénéiser la solution tout en offrant une répartition des lignes de courant relativement homogène.

L'échantillon 12 présente également une face arrière 13, opposée à la face avant 11, qui est en contact ohmique sec avec une électrode de travail 7 présentant une tête d'amenée de courant 7a et des motifs de structuration 14 mis en contact ohmique sec - contact dans lequel l'électrolyte n'intervient pas - avec la face arrière 13 de l'échantillon et déterminant, le long du contact ohmique, des parties isolantes 15 et des parties conductrices 16, qui sont aptes à définir un motif à structurer sur la face avant 11 de l'échantillon 12. Les parties isolantes 15 sont des évidements isolants par la présence d'air, et les parties conductrices 16 sont formées en relief.

La face arrière 13 de l'échantillon 12 est reliée au circuit électrique 5 par une électrode 7 dont la tête 7a d'amenée de courant présente des motifs de structuration 14a intégralement formés (figure 5) sur sa surface destinée à entrer en contact avec la face arrière 13 du matériau.

La tête d'amenée 7a de courant, représentée figure 4, étant conductrice, elle est en générale métallique. La structuration directe de sa surface peut se faire par gravure pour aboutir à l'électrode à surface structurée de la figure 5. Pour une gravure nanométrique, il est préférentiellement utilisé la lithographie couplée à une gravure ionique réactive.

La figure 6 illustre une alternative à la structuration directe de l'électrode qui consiste à réaliser un masque 14b conducteur et structuré, appliqué, de manière amovible, en contact ohmique avec une tête d'amenée 7 de courant non structurée.

Ce masque 14b peut être fabriqué par toutes les techniques disponibles permettant d'obtenir des parties conductrices et des parties isolantes. A titre d'exemple pour le domaine nanométrique, il est possible d'utiliser un échantillon conducteur ou semi-conducteur qui a été préalablement gravé. Les échantillons de silicium collés-toumés et gravés à leur surface, décrits précédemment, peuvent constituer un tel masque 14b.

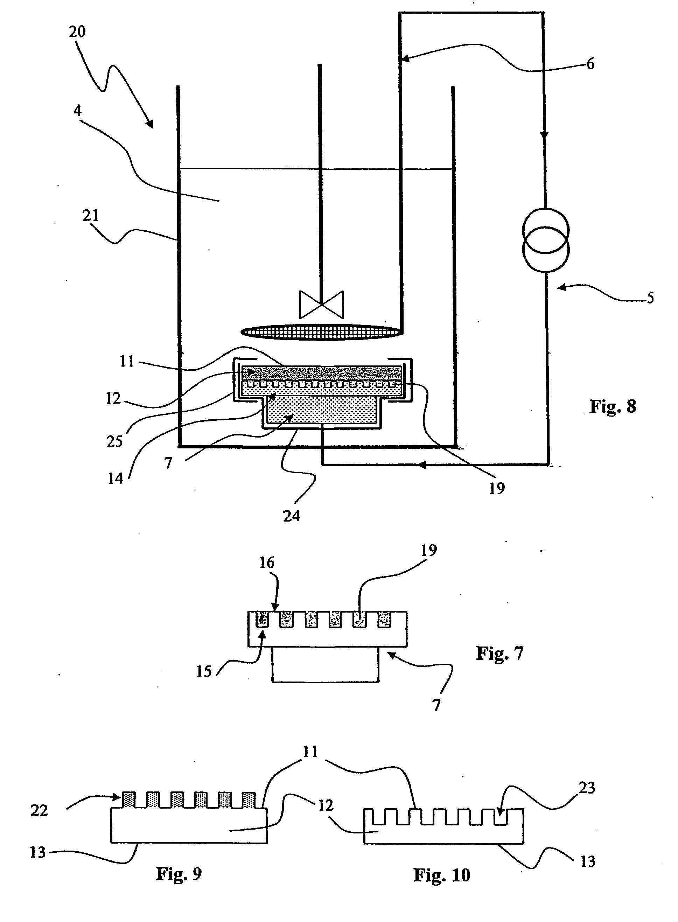

Dans ces modes de réalisation, l'air peut être suffisant comme isolant, mais il est possible de déposer un matériau plus isolant 19 que l'air dans les évidements gravés 15 (figure 7), par exemple lorsque il existe un risque de transfert de charge entre les reliefs conducteurs 16 à travers les évidements isolants 15 par effet tunnel.

En effet, le transfert des charges à travers une barrière isolante est un point important pour respecter les tailles caractéristiques de gravure. En mode galvanostatique, les réactions électrochimiques réalisées (gravure ou dépôt) sont obtenues à densité de courant j constante pour un couple densité de courant/différence de potentiel de l'ordre de 100 µA/cm² à quelques centaines de µA/cm² pour j et 1 Volt maximum pour V, mais en général moins. Pour ces valeurs et en utilisant l'air comme isolant le courant ne passe pas pour des tailles de motifs micrométriques et même jusqu'à quelques centaines de nanomètres. Pour le domaine nanométrique (100 nm et jusqu'à quelques nanomètres) le courant peut passer par effet tunnel, mais pour des faibles valeurs de courant il est arrêté au dessus de 10 nm d'air.

Le matériau isolant 19 est déposé de façon à ce qu'il affleure les reliefs conducteurs pour que le contact entre l'électrode et l'échantillon se fasse continûment sur la surface de la face arrière 13 de l'échantillon 12.

Les échantillons 12 à structurer utilisables dans les procédés selon l'invention (décrits par la suite) sont obligatoirement des matériaux conducteurs, semi conducteurs fortement dopés ou semi conducteurs faiblement dopés.

Les matériaux semi-conducteurs fortement dopés (en nombre d'éléments dopants supérieur à 10¹⁸ par cm³, et de résistivité ρ inférieure à 0,01 Ocm) ont un comportement métallique et par voie de conséquence ont un bon contact ohmique avec la tête d'amenée de courant 7.

En revanche les matériaux 12 semi-conducteurs faiblement dopés (en nombre d'éléments dopants inférieur à 10¹⁶ cm⁻³, et de résistivité p de 4 à 6 Ocm) doivent avoir un dépôt métallique sur la face arrière 13 (par exemple, de l'aluminium) et un recuit de manière à avoir un contact ohmique suffisant pour obtenir la réaction électrochimique voulue.

La cellule d'électrochimie comprend en outre un moyen de maintien (non représenté) de l'échantillon 12 contre le joint 10 et un moyen de mise en contact ohmique sec (non représenté) de la face arrière 13 de l'échantillon 12 avec le moyen de masquage 14, ces fonctions pouvant être assurées par un serrage appliquant la tête d'amenée de courant 7 contre le moyen de masquage 14, lui-même contre le matériau 12, lui-même comprimant le joint 10. Les deux électrodes 6 et 7 sont reliées par le circuit électrique 5 comprenant un galvanostat/potentiostat 17 et un agitateur 18 en rotation est préférentiellement utilisé pour homogénéiser la solution électrolytique 4. II est généralement en Teflon® et son diamètre peut être, par exemple, de 10 mm pour la tige et 25 mm pour « l'hélice ».

Lorsque le circuit électrique 5 est fermé, un courant électrique j s'établit entre le matériau et la tête d'amenée de courant sous une différence de potentiel V, le galvanostat/potentiostat 17 pouvant délivrer soit un courant constant soit une tension constante.

Le procédé de structuration électrochimique mis en oeuvre par le dispositif 1, décrit précédemment, consiste à disposer la face avant 11 de l'échantillon 12 en contact avec l'électrolyte 4, à disposer, dans l'électrolyte 4, la contre-électrode 6 en regard de la face avant 11 de l'échantillon 12 qui doit être structurée, à disposer la l'électrode de travail 7 en contact ohmique sec avec la face arrière 13 de l'échantillon 12 et présentant des motifs de structuration 14a ou 14b, et à appliquer un courant électrique entre les deux électrodes pour obtenir une réaction électrochimique à l'interface de la face avant 11 de l'échantillon 12 et de l'électrolyte 4 avec une densité de courant qui est modulée par les motifs de structuration 14a ou 14b de l'électrode de travail 7 pour former une gravure ou un dépôt sur la face avant 11 de l'échantillon 12.

La réaction électrochimique a alors lieu à l'interface face avant 11/électrolyte 4. Suivant le sens du courant, si la tête 7 d'amenée de courant est à l'anode et la contre électrode de platine 6 à la cathode, il se produit une réaction d'oxydation sur la face avant 11, donc une gravure. A l'inverse si la tête 7 d'amenée de courant est à la cathode et la contre-électrode de platine 6 à l'anode, il se produit une réaction de réduction sur la face avant 11 de l'échantillon 12, donc un dépôt.

Compte tenu de la structuration 14, les lignes de champ ne s'appliquent qu'aux points de contact entre la face arrière 13 de l'échantillon 12 et la tête d'amenée de courant 7 et se transmettent à travers l'échantillon avec une modulation latérale, à condition que les distances caractéristiques d et d' ne soient pas trop petites pour un couple j-V donné (figure 5). La réaction électrochimique a lieu à l'interface électrolyte 4- face avant 11 avec une densité de courant modulée. La réaction sera donc plus rapide aux lieux de forte densité de courant, et moins rapide où la densité de courant est plus faible. Cette modulation de la densité de courant est dépendante du motif imprimé sur la tête 7 d'amenée de courant:

Ainsi, selon l'invention, le masquage appliqué sur la face arrière 13 s'exprime à travers le matériau 12 conducteur ou semi-conducteur et la structuration se fait sur la face avant 11.

Une fois la tête 7a d'amenée de courant structurée 14a - ou munie d'un masque 14b - il est possible de reproduire le motif sur un échantillon 12 par réaction électrochimique (dépôt ou gravure) autant de fois que nécessaire en une seule étape technologique nécessitant peu d'opérations.

Il est ainsi possible de réaliser, par voie électrochimique, le dépôt ou la croissance de nanostructures - par exemple de nano fils 22 - (figure 9), ou la gravure de nanostructures - par exemple de nano sillons 23 - (figure 10) de manière simple, rapide, peu coûteuse et répétée.

Les choix de l'électrolyte 4 et du branchement des électrodes 6 et 7 déterminent les réactions et les structurations obtenues.

### ■ Exemples de gravure anodique

Pour réaliser une gravure de l'échantillon 12, l'électrode de travail 7 est reliée au circuit électrique 5 de façon à constituer une anode. Il se produit alors, sur la face avant 11, une réaction d'oxydation. Pour réaliser une gravure, une solution électrolytique 4 acide est généralement choisie. Elle est prise préférentiellement, mais non exclusivement, dans le groupe constitué par l'acide fluorhydrique , l'acide chlorhydrique, l'acide orthophosphorique, l'acide oxalique, l'acide sulfurique et l'acide chromique.

### ➢ Exemple 1 : obtention d'un électropolissage localisé de silicium en mode galvanostatique

L'électrolyte choisi est une solution d'acide fluorhydrique de concentration comprise entre 0.5 et 5 % en volume/volume.

L'échantillon 12 à structurer est une plaque de silicium dont la face avant 11 est placée en contact avec cette solution d'acide fluorhydrique faiblement concentrée. Puis une électrode de travail 7 structurée 14a ou munie d'un masque 14b est placée en contact sec avec la face arrière 13, située à l'opposée de la face avant 11. Lorsque le courant traverse la plaque de silicium, il se produit à l'interface électrolyte 4-face avant 11, une réaction d'oxydation localisée en face des reliefs conducteurs déterminant le motif à structurer. Les valeurs de courant, de voltage et de temps sont adaptées en fonction de la profondeur voulue de la gravure, des distances qui séparent les reliefs conducteurs et de la présence ou non de matériau isolant - afin d'éviter l'effet tunnel.

### ➢ Exemple 2 : obtention de silicium poreux à super-structure poreuse ordonnée en mode galvanostatique

L'électrolyte choisi est une solution d'acide fluorhydrique éthanoïque de concentration pour l'acide comprise entre 15 et 25 % en volume. L'ajout d'éthanol permet une meilleure évacuation du dégagement d'hydrogène qui apparaît au cours de la réaction. La concentration en éthanol dans la solution est de 50%.

Le procédé est le même que précédemment, mais la solution électrolytique est plus concentrée. Ici encore, les valeurs de courant, de voltage et de temps sont adaptées en fonction de la profondeur voulue de la gravure, des distances qui séparent les reliefs conducteurs et de la présence ou non de matériau isolant - afin d'éviter l'effet tunnel.

Du fait de la structuration de l'électrode en contact sec, les porosités, désordonnées, présentent une super-structure ordonnée. Ainsi la structure poreuse désordonnée peut être obtenue uniquement localement, à des positions contrôlées par le dessin gravé sur la face 14a de la tête d'amenée de courant 7 ou le masque 14b, ou son négatif. De plus, la taille des porosités est faible.

### ➢ Exemple 3 : obtention d'oxyde de silicium localisé en mode galvanostatique

L'électrolyte choisi est une solution d'acide chlorhydrique de concentration comprise entre 0,1 et 1 M. Le procédé est identique à ceux décrits précédemment. Ici encore, les valeurs de courant, de voltage et de temps sont adaptées en fonction de la profondeur voulue de la gravure, des distances qui séparent les reliefs conducteurs et de la présence ou non de matériau isolant - afin d'éviter l'effet tunnel.

Enfin, le procédé selon l'invention permet aussi, par exemple, d'obtenir, en milieu acide (orthophosphorique, oxalique, sulfurique, chromique,...), facilement et de manière hautement reproductible, de l'alumine poreuse suivant le motif gravé sur l'électrode de travail qui permet, notamment, une protection contre la corrosion et une isolation électrique. Pour ce faire, le dispositif est utilisé en mode potentiostatique, la tension appliquée déterminant la distance entre les pores.

### ■ Dépôts cathodiques

Pour obtenir un dépôt sur la face avant 11 de l'échantillon 12, l'électrode de travail 7 est reliée au circuit électrique 5 de façon à constituer une cathode. II se produit alors, sur la face avant 11, une réaction de réduction.

La réduction cathodique permet la réalisation de dépôts métalliques - par exemple : Mg, Ni, Pd, Fe, Sn -, mais aussi d'alliages - par exemple : Cu-Sn, Cu-Zn, Ni-Zn.

En fonction du matériau à déposer, on utilise des solutions électrolytiques adaptées, du type CuSO₄ en concentration molaire pour déposer du cuivre, SnSO₄ pour déposer de l'étain, CoSO₄, pour déposer du cobalt, FeSO₄, pour déposer du fer, NiSO₄, pour déposer du nickel, ZnSo₄ pour déposer du zinc etc...

Selon les structurations (gravure ou dépôt) réalisées, en mode galvanostatique, les valeurs de courant sont choisies entre moins de 100 µA/cm² à plus de 100 mA/cm². En mode potentiostatique, les valeurs de la tension sont choisies entre 1 Volt et 100 Volts.

Le remplissage des évidements 15 par de la matière isolante 19 peut aussi permettre de réaliser un deuxième mode de réalisation de l'invention, représenté dans la figure 8.

Contrairement au dispositif de structuration électrochimique 1 de la figure 1, le dispositif de structuration électrochimique 20 de la figure 8 présente un réservoir 21 non ajouré. L'échantillon 12 et les première 6 et seconde 7 électrodes sont situées dans l'électrolyte 4 avec un moyen d'étanchéité 19 agencé pour maintenir les motifs de structuration 14 en contact ohmique sec avec la face arrière 13 de l'échantillon 12 lorsque l'ensemble est entièrement plongé dans l'électrolyte. Pour cela des mâchoires de serrage seront utilisées pour maintenir le serrage.

Dans le mode de réalisation illustré, le matériau isolant 19 a été choisi pour être étanche à l'électrolyte 4 de façon à empêcher celui-ci de s'insinuer dans les évidements 15 et à permettre la structuration de la face avant 11 de l'échantillon 12 bien que l'ensemble soit dans l'électrolyte 4. En outre, la tête d'amenée de courant devrait être recouverte d'un matériau 24 isolant électriquement tout en étant inerte aux solutions électrolytiques.

Le contact entre les moyens de masquage 14 et la face arrière 13 de l'échantillon 12 peut donc aussi être qualifié de sec dans ce mode de réalisation car même lorsque l'électrode de travail 7 est plongé dans l'électrolyte 4, elle est plaquée sur toute sa surface 14a (ou 14b lorsque les motifs de structurations sont portés par un masque amovible plaqué en contact ohmique sur l'électrode) contre la face arrière 13 de l'échantillon 12, de sorte que l'électrolyte 4 ne puisse s'insérer ou subsister entre la face arrière 13 de l'échantillon 12 et la surface déterminée par les reliefs conducteurs 16 et le matériau isolant 19 affleurant.

Bien entendu, un moyen de maintien en contact 25 (mâchoires de serrage) de l'ensemble constitué par le matériau à structurer 12, les motifs de structuration 14 et l'électrode de travail 7 est prévu pour que le contact ohmique reste sec.

Pour réaliser une structuration électrochimique avec le dispositif 20 :
- on relie électriquement la face arrière 13 de l'échantillon 12 au circuit électrique 5 par l'intermédiaire d'un contact ohmique sec avec des moyens de masquage 14 reliés électriquement à la tête 7 d'amenée de courant,
- on dispose un moyen d'étanchéité pour maintenir les évidements isolants 15 en contact sec avec la face arrière 13 - l'étanchéité pouvant être obtenue en choisissant un matériau isolant 19 adapté pour être étanche à l'électrolyte 4 ou en disposant un joint d'étanchéité autour de l'interface entre la face arrière 13 et le masque 14 -,
- on dispose la face avant 11 de l'échantillon 12 en contact avec l'électrolyte 4 en plongeant complètement dans l'électrolyte 4 l'ensemble matériau 12- moyen de masquage 14- tête 7 d'amenée de courant, puis
- on dispose dans l'électrolyte 4 une contre-électrode 6 en regard de la face avant 11 de l'échantillon 12.

Lorsque le circuit électrique 5 est fermé, le mode d'obtention et les résultats de la structuration sont obtenus de la même façon que dans le premier mode de réalisation.

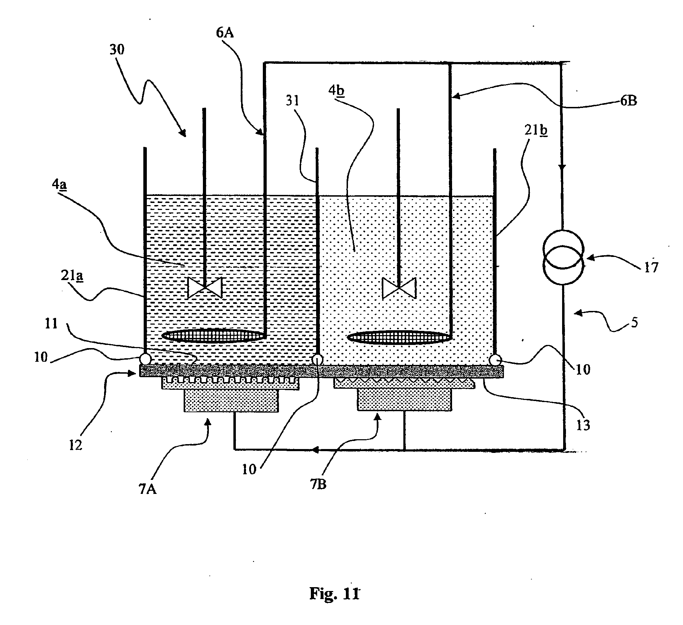

Le mode de réalisation représenté dans la figure 11, illustre un dispositif de structuration électrochimique 30 qui présente un réservoir 21a et un réservoir 21b séparés l'un de l'autre par au moins une paroi étanche 31.

Chaque réservoir 21a et 21b comprend respectivement un électrolyte 4a et 4b, pouvant être identiques ou différents selon les structurations voulues par l'utilisateur. Le fond des réservoirs 21a et 21b est ajouré et présente un joint d'étanchéité 10 apte à entrer en contact avec la face supérieure 11 de l'échantillon 12 à structurer.

Deux électrodes de travail 7A et 7B sont placées en contact ohmique sec contre la face arrière 13 de l'échantillon 12, chacune sensiblement en regard avec une contre-électrode 6A et 6B. Les deux électrodes de travail- 7A et 7B- présentent des motifs de structuration différents, de sorte qu'il est possible de réaliser simultanément deux régions structurées de manière identique ou différente, selon l'électrolyte employé, sur l'échantillon 12. Bien entendu, il est possible de réaliser plus de deux régions identiques ou différentes en prévoyant plusieurs réservoirs et plusieurs couples de contre-électrode/électrode de travail. En outre, le dispositif de la figue 11 peut fonctionner avec plusieurs sources de courant constant et/ou de tension constante, par exemple sous la forme d'un multi galvanostat/potentiostat.

Selon d'autres caractéristiques de l'invention :
■ le contact sec peut être obtenu avec une cellule d'électrochimie classique à fond non ouvert en plaçant la face avant du matériau contre la surface de l'électrolyte et en laissant la face arrière du matériau hors de l'électrolyte. Dans ce- cas, il peut être- utile- de- prévoir un moyen de positionnement adaptable du matériau si le niveau de l'électrolyte change
   - par exemple par évaporation ;
■ les moyens de masquages peuvent être constitués par un matériau constitué d'une juxtaposition latérale de couches conductrices et de couches isolantes, ces dernières pouvant être choisies, en outre, étanche à l'électrolyte ;
■ Le moyen d'étanchéité peut être un joint entourant les moyens de masquage 14 de sorte que lorsqu'ils sont appliqués en contact sec avec la face arrière 13 de l'échantillon 12, l'électrolyte ne peut s'insinuer dans les évidements 15.

### Références bibliographiques citées

- G. Wallis and D.I. Pomerantz J. Appl. Phys. 40, 3946 (1969).
- M. Schimbo, K. Furukawa, K. Fukuda and K. Tanzawa, J. Appl. Phys. 60, 2987 (1986).
- D. Buttard, J. Eymery, F. Fournel, P. Gentile, F. Leroy, N. Magnéa, H. Moriceau, G. Renaud, F. Rieutord, K. Rousseau, J.L. Rouvière, IEEE, J. Quantum electronics 38, 995-1005 (2002).
- F. Fournel, H. Moriceau, B. Aspar, K. Rousseau, J. Eymery ; J.L. Rouvière, N. Magnéa, Appl. Phys. Lett. 80, 793 (2002).
- F. Leroy, J. Eymery, P. Gentile, F. Fournel, Surface Science 545, 211 (2003).
- R.S. Wagner and W.C. Ellis Appl. Phys. Lett. 4, 89 (1964).
- J. W. Dailey, J. Taraci and T Clement, J. Appl. Phys., 96 (12), 15 December 2004
- T. Martensson, P. Carlberg, M. Borgström, L. Montelius, W. Seifert, L. Samuelson, Nanoletters 4, 699 (2004).
- A. Ulhir, Bell System Tech. J. 35 333 (1956).
- D.R. Turner, J. Electrochem. Soc. 105, 402 (1958)
- G. Cullis, L. T. Canham, P. D. J. Calcott, J. Appl. Phys. 82, 909 (1997).
- T. Nakagawa, H. Sugiyama, N. Koshida, Jpn J. Appl. Phys. 37, 7186 (1998).
- G. Lerondel, R. Romestain, J.C. Vial, M. Thönissen Appl. Phys. Lett. 71, 196 (1997).
- Heidari, L. Olsson, demande de brevet international WO 99/45179 (10 Septembre 1999), date de priorité : 5 Mars 1998.
- P. Möller, M. Fredenberg, P. Wiven-Nilsson, demande de brevet international WO 02/103085 A1 (27 Décembre 2002), date de priorité : 15 Juin 2001.
- S. JIN, demande de brevet international WO 2004/099469 A2 (18 Novembre 2004), date de priorité : 9 Avril 2003.

## Revendications

1. Procédé de micro et/ou nano-structuration électrochimique d'un échantillon (12) en un matériau conducteur ou semi-conducteur et comprenant deux faces opposées, une face avant (11) et une face arrière (13), **caractérisé en ce qu'**il comprend les étapes consistant à :
(a) mettre au moins la face avant (11) de l'échantillon (12) en contact avec au moins une solution électrolytique (4, 4a, 4b) stockée dans au moins un réservoir (3, 21, 21a, 21b) ;
(b) disposer au moins une contre-électrode (6, 6A, 6B) dans un électrolyte (4, 4a, 4b) en regard de la face avant (11) de l'échantillon (12), cette face avant (11) devant être structurée ;
(c) disposer au moins une électrode de travail (7, 7A, 7B) en contact ohmique sec avec la face arrière (13) de l'échantillon-(12) et présentant des motifs de structuration (14, 14a, 14b) ; et
(d) appliquer un courant électrique entre au moins une contre électrode (6, 6A, 6B) et une électrode de travail (7, 7A, 7B) qui sont sensiblement en regard l'une de l'autre pour obtenir une réaction électrochimique à l'interface de la face avant (11) de l'échantillon (12) et de l'électrolyte (4, 4a, 4b) avec une densité de courant qui est modulée par les motifs de structuration (14, 14a, 14b) de l'électrode de travail (7, 7A, 7B) pour former une gravure et/ou un dépôt sur la face avant (11) de l'échantillon (12).

2. Procédé de structuration électrochimique selon la revendication 1, dans lequel en fonction du sens du courant la réaction électrochimique est soit une réaction d'oxydation conduisant à une gravure de la face avant (11) de- l'échantillon (12), soit une réaction de réduction conduisant à un dépôt sur la face avant (11) de l'échantillon (12).

3. Procédé de structuration électrochimique selon la revendication 2, dans lequel la réaction d'oxydation conduisant à une gravure est obtenue en faisant jouer à au moins une contre-électrode (6, 6A, 6B) le rôle d'une cathode et à l'électrode de travail (7, 7A, 7B) sensiblement en regard le rôle d'une anode, et avec une solution électrolytique (4) de préférence acide.

4. Procédé de gravure électrochimique selon la revendication 3, dans lequel on utilise de l'acide fluorhydrique, l'acide chlorhydrique, l'acide orthophosphorique, l'acide oxalique, l'acide sulfurique ou l'acide chromique, avec des concentrations variables.

5. Procédé de structuration électrochimique selon la revendication 2, dans lequel la réaction de réduction conduisant à un dépôt est obtenue en faisant jouer à au moins une contre-électrode (6, 6A, 6B) le rôle d'une anode et à l'électrode de travail (7, 7A, 7B) sensiblement en regard le rôle d'une cathode, et avec une solution électrolytique (4) qui est fonction du matériau à déposer sur la face avant (11) de l'échantillon (12).

6. Dispositif de structuration électrochimique- d'un échantillon (12) en un matériau conducteur ou semi-conducteur et comprenant deux faces opposées, une face avant (11) et une face arrière (13), pour la mise en oeuvre du procédé selon l'une quelconque des revendications 1 à 5, comprenant une cellule d'électrochimie (2), munie d'au moins un réservoir (3, 21, 21a, 21b) contenant un électrolyte (4, 4a, 4b) et d'un circuit électrique (5) relié à au moins une contre-électrode (6, 6A, 6B) et à au moins une électrode de travail (7, 7A, 7B), **caractérisé en ce que** au moins une contre-électrode (6) est positionnée en regard de la face avant (11) de l'échantillon (12), et la face arrière (13) de l'échantillon (12) est mise en contact ohmique sec avec au moins une électrode de travail (7, 7A, 7B), celle-ci présentant des motifs de structuration (14, 14a, 14b) déterminant, le long du contact ohmique, des parties isolantes (15) et des parties conductrices (16), ces dernières correspondant au motif à graver et/ou déposer sur la face avant (11) de l'échantillon (12).

7. Dispositif de structuration électrochimique selon la revendication 6, dans lequel seule la face avant (11) est en contact avec l'électrolyte (4, 4a, 4b), la face arrière (13) étant au sec par rapport à l'électrolyte (4, 4a, 4b).

8. Dispositif de structuration électrochimique selon la revendication 7, dans lequel le réservoir (3) présente un fond (8) muni d'une ouverture (9) et la face avant (11) de l'échantillon (12) est plaquée contre l'ouverture (9) avec interposition d'un joint d'étanchéité (10).

9. Dispositif de structuration électrochimique selon la revendication 8, dans lequel le joint (10) est réalisé en élastomère fluoré.

10. Dispositif de structuration électrochimique selon la revendication 6, dans lequel l'échantillon (12) et les électrodes (6, 7) sont situées dans l'électrolyte (4) avec un moyen d'étanchéité (19) agencé pour maintenir les motifs de structuration (14, 14a, 14b) en contact sec avec la face arrière (13) de l'échantillon (12).

11. Dispositif de structuration électrochimique selon l'une quelconque des revendications 6 à 10, dans lequel au moins une électrode de travail (7) comprend d'une tête d'amenée de courant (7) présentant une surface structurée (14a) destinée à être mise en contact ohmique avec la face arrière (13) de l'échantillon (12) et comprenant des reliefs conducteurs (16) déterminant le motif à structurer et des évidements isolants (15).

12. Dispositif de structuration électrochimique selon la revendication 11, dans lequel la surface structurée (14a) de la tête d'amenée de courant (7) est obtenue par lithographie couplée à une gravure ionique réactive.

13. Dispositif de structuration électrochimique selon l'une quelconque des revendications 6 à 12, dans lequel au moins une électrode de travail (7) comprend une tête d'amenée de courant (7) en contact ohmique avec un masque (14b) amovible présentant des motifs de structuration comprenant des reliefs conducteurs (16) déterminant le motif à structurer et des évidements isolants (15).

14. Dispositif de structuration électrochimique selon la revendication 13, dans lequel le masque (14b) est un échantillon de silicium collé/tourné et gravé pour présenter les reliefs conducteurs (16) déterminant le motif à structurer et les évidements isolants (15).

15. Dispositif de structuration électrochimique selon l'une quelconque des revendications 11 à 14, dans lequel les évidements (15) sont remplis d'un matériau isolant (19) affleurant les reliefs conducteurs (16).

16. Dispositif de structuration électrochimique selon les revendications 10 et 15, dans lequel le matériau isolant (19) est étanche à l'électrolyte (4).

17. Dispositif de structuration électrochimique selon l'une quelconque des revendications 6 à 16, dans lequel le circuit électrique (5) comprend au moins une alimentation constituée par un galvanostat/potentiostat (17).

18. Dispositif de structuration électrochimique selon l'une quelconque des revendications 6 à 17, dans lequel une contre- électrode (6) est une électrode de platine conformé en disque-grille ou en panier sans fond.

19. Dispositif de structuration électrochimique selon l'une quelconque des revendications 6 à 18, comprenant en outre un moyen d'agitation (18) de l'électrolyte (4).

## Claims

1. A method of electrochemically micro- and/or nano-structuring a sample (12) of a conductive or semiconductor material having two opposite faces, namely a front face (11) and a rear face (13), the method being **characterized in that** it comprises the steps consisting in:
a) putting at least the front face (11) of the sample (12) into contact with at least one electrolytic solution (4, 4a, 4b) stored in at least one tank (3, 21, 21a, 21b);
b) placing at least one counter-electrode (6, 6A, 6B) in an electrolyte (4, 4a, 4b) in register with the front face (11) of the sample (12), said front face (11) being for structuring;
c) placing at least one working electrode (7, 7A, 7B) presenting structuring patterns (14, 14a, 14b) into dry ohmic contact with the rear face (13) of the sample (12); and
d) applying an electric current between at least one counter-electrode (6, 6A, 6B) and at one least working electrode (7, 7A, 7B) that are substantially in register with each other in order to obtain an electrochemical reaction at the interface between the front face (11) of the sample (12) and the electrolyte (4, 4a, 4b) with current density that is modulated by the structuring patterns (14, 14a, 14b) of the working electrode (7, 7A, 7B) in order to perform etching and/or deposition on the front face (11) of the sample (12).

2. An electrochemical structuring method according to claim 1, in which, depending on the flow direction of the current, the electrochemical reaction is either an oxidation reaction leading to etching of the front face (11) of the sample (12), or a reduction reaction leading to deposition on the front face (11) of the sample (12).

3. An electrochemical structuring method according to claim 2, in which the oxidation reaction leading to etching is obtained by causing at least one counter-electrode (6, 6A, 6B) to act as a cathode and the working electrode (7, 7A, 7B) substantially in register therewith to act as an anode, and using an electrolytic solution (4) that is preferably acidic.

4. An electrochemical structuring method according to claim 3, in which use is made of: hydrofluoric acid; hydrochloric acid; orthophosphoric acid; oxalic acid; sulfuric acid; or chromic acid; and at varying concentrations.

5. An electrochemical structuring method according to claim 2, in which the reduction reaction leading to a deposit is obtained by causing at least one counter-electrode (6, 6A, 6B) to act as an anode and causing the working electrode (7, 6A, 7B) substantially in register therewith to act as a cathode, and with an electrolytic solution (4) that is a function of the material that is to be deposited on the front face (11) of the sample (12).

6. A device for electrochemically structuring a sample (12) of a conductive or semiconductor material that has two opposite faces, namely a front face (11) and a rear face (13), the device serving to implement the method according to any one of claims 1 to 5, the device comprising an electrochemical cell (2) provided with at least one tank (3, 21, 21a, 21b) containing an electrolyte (4, 4a, 4b) and an electric circuit (5) connected to at least one counter-electrode (6, 6A, 6B) and to at least one working electrode (7, 7A, 7B), the device being **characterized in that** at least one counter-electrode (6) is positioned in register with the front face (11) of the sample (12), and the rear face (13) of the sample (12) is put into dry ohmic contact with at least one working electrode (7, 7A, 7B) that presents structuring patterns (14, 14a, 14b) that define, along the ohmic contact, insulating portions (15) and conductive portions (16), which portions correspond to the pattern to be etched and/or deposited on the front face (11) of the sample (12).

7. An electrochemical structuring device according to claim 6, in which only the front face (11) is in contact with the electrolyte (4, 4a, 4b), the rear face (13) being dry relative to the electrolyte (4, 4a, 4b).

8. An electrochemical structuring device according to claim 7, in which the tank (3) presents a bottom (8) provided with an opening (9), and the front face (11) of the sample (12) is placed against the opening (9) with an interposed sealing gasket (10).

9. An electrochemical structuring device according to claim 8, in which the gasket (10) is made of a fluoroelastomer.

10. An electrochemical structuring device according to claim 6, in which the sample (12) and the electrodes (6, 7) are situated in the electrolyte (4) with sealing means (19) arranged to keep the structuring patterns (14, 14a, 14b) in dry contact with the rear face (13) of the sample (12).

11. An electrochemical structuring device according to any one of claims 6 to 10, in which at least one working electrode (7) comprises a current feed head (7a) presenting a structured surface (14a) for putting into ohmic contact with the rear face (13) of the sample (12) and comprising conductive portions in relief (16) determining the pattern to be structured, and also comprising insulating gaps (15).

12. An electrochemical structuring device according to claim 11, in which the structured surface (14a) of the current feed head (7) is obtained by lithography coupled with reactive ionic etching.

13. An electrochemical structuring device according to any one of claims 6 to 12, in which at least one working electrode (7) comprises a current feed head (7) in ohmic contact with a removable mask (14b) presenting structuring patterns comprising conductive portions in relief (16) defining the pattern to be structured together with insulating gaps (15).

14. An electrochemical structuring device according to claim 13, in which the mask (14b) is a sample of twisted and bonded silicon that has been etched to present the conductive portions in relief (16) defining the pattern to be structured and the insulating gaps (15).

15. An electrochemical structuring device according to any one of claims 11 to 14, in which the gaps (15) are filled with an insulating material (19) flush with the conductive portions in relief (16).

16. An electrochemical structuring device according to claims 10 and 15, in which the insulating material (19) is proof to the electrolyte (4).

17. An electrochemical structuring device according to any one of claims 6 to 16, in which the electric circuit (5) includes at least one power supply constituted by a galvanostat/potentiostat (17).

18. An electrochemical structuring device according to any one of claims 6 to 17, in which a counter-electrode (6) is a platinum electrode shaped as a grid disk or a bottomless basket.

19. An electrochemical structuring device according to any one of claims 6 to 18, further including means (18) for stirring the electrolyte (4).

## Patentansprüche

1. Verfahren zum elektrochemischen Mikro- und/oder Nanostrukturieren eines Werkstücks (12) aus einem leitenden oder halbleitenden Material mit zwei einander entgegengesetzten Seiten, einer Vorderseite (11) und einer Rückseite (13), **dadurch gekennzeichnet, dass** das Verfahren die folgenden Schritte umfasst, bestehend aus:
(a) Inkontaktbringen mindestens der Vorderseite (11) des Werkstück (12) mit mindestens einer, in mindestens einem Behälter (3, 21, 21a 21b) bevorrateten Elektrolytlösung (4, 4a, 4b);
(b) Anordnen mindestens einer Gegenelektrode (6, 6A, 6B) in einem Elektrolyt (4, 4a, 4b) gegenüber von der Vorderseite (11) des Werkstück (12), wobei diese Vorderseite (11) strukturiert werden soll;
(c) Anordnen mindestens einer Arbeitselektrode (7, 7A, 7B), welche in trockenem ohmschen Kontakt mit der Rückseite (13) des Werkstück (12) steht und Strukturierungsmuster (14, 14a, 14b) aufweist; und
(d) Anlegen eines elektrischen Stroms zwischen mindestens einer Gegenelektrode (6, 6A, 6B) und einer Arbeitselektrode (7, 7A, 7B), die einander im Wesentlichen gegenüber liegen, um eine elektrochemische Reaktion an der Grenzfläche der Vorderseite (11) des Werkstück (12) und des Elektrolyts (4, 4a, 4b) zu erhalten, mit einer Stromdichte, die von den Strukturierungsmustern (14, 14a, 14b) der Arbeitselektrode (7, 7A, 7B) moduliert wird, um eine Ätzung und/oder eine Abscheidung auf der Vorderseite (11) des Werkstück (12) auszubilden.

2. Verfahren zum elektrochemischen Strukturieren nach Anspruch 1, wobei die elektrochemische Reaktion in Abhängigkeit von der Richtung des Stroms entweder eine Oxidationsreaktion ist, die zu einer Ätzung der Vorderseite (11) des Werkstück (12) führt, oder eine Reduktionsreaktion, die zu einer Abscheidung auf der Vorderseite (11) des Werkstück (12) führt.

3. Verfahren zum elektrochemischen Strukturieren nach Anspruch 2, wobei die zu einer Ätzung führende Oxidationsreaktion erhalten wird, indem mindestens einer Gegenelektrode (6, 6A, 6B) die Rolle einer Kathode und der im Wesentlichen gegenüber liegenden Arbeitselektrode (7, 7A, 7B) die Rolle einer Anode zugewiesen wird, und mit einer vorzugsweise sauren Elektrolytlösung (4).

4. Verfahren zum elektrochemischen Ätzen nach Anspruch 3, wobei Fluorwasserstoffsäure, Salzsäure, Orthophosphorsäure, Oxalsäure, Schwefelsäure oder Chromsäure mit veränderlichen Konzentrationen verwendet wird.

5. Verfahren zum elektrochemischen Strukturieren nach Anspruch 2, wobei die zu einer Abscheidung führende Reduktionsreaktion erhalten wird, indem mindestens einer Gegenelektrode (6, 6A, 6B) die Rolle einer Anode und der im Wesentlichen gegenüber liegenden Arbeitselektrode (7, 7A, 7B) die Rolle einer Kathode zugewiesen wird, und mit einer Elektrolytlösung (4), die von dem auf der Vorderseite (11) des Werkstück (12) abzuscheidenden Material abhängt.

6. Vorrichtung zum elektrochemischen Strukturieren eines Werkstücks (12) aus einem leitenden oder halbleitenden Material mit zwei einander entgegengesetzten Seiten, einer Vorderseite (11) und einer Rückseite (13), für die Anwendung des Verfahrens nach einem der Ansprüche 1 bis 5, wobei die Vorrichtung eine elektrochemische Zelle (2) aufweist, die mit mindestens einem, ein Elektrolyt (4, 4a, 4b) enthaltenden Behälter (3, 21, 21a, 21b) und einem, mit mindestens einer Gegenelektrode (6, 6A, 6B) und mindestens einer Arbeitselektrode (7, 7A, 7B) verbundenen Stromkreis (5) versehen ist, **dadurch gekennzeichnet, dass** mindestens eine Gegenelektrode (6) gegenüber von der Vorderseite (11) des Werkstücks (12) positioniert ist, und die Rückseite (13) des Werkstück (12) in trockenem ohmschen Kontakt mit mindestens einer Arbeitselektrode (7, 7A, 7B) steht, wobei die letztere Strukturierungsmuster (14, 14a, 14b) aufweist, welche entlang des ohmschen Kontaktes isolierende Abschnitte (15) und leitende Abschnitte (16) festlegen, die dem auf der Vorderseite (11) des Werkstück (12) zu ätzenden und/oder abzuscheidenden Muster entsprechen.

7. Vorrichtung zum elektrochemischen Strukturieren nach Anspruch 6, wobei einzig die Vorderseite (11) mit dem Elektrolyt (4, 4a, 4b) in Kontakt steht, und die Rückseite (13) im Hinblick auf das Elektrolyt (4, 4a, 4b) unbenetzt ist.

8. Vorrichtung zum elektrochemischen Strukturieren nach Anspruch 7, wobei der Behälter (3) einen mit einer Öffnung (9) versehenen Boden (8) aufweist, und die Vorderseite (11) des Werkstück (12) unter dazwischen liegender Anordnung eines Dichtelementes (10) an der Öffnung (9) anliegt.

9. Vorrichtung zum elektrochemischen Strukturieren nach Anspruch 8, wobei die Dichtung (10) aus fluoriertem Elastomer ausgeführt ist.

10. Vorrichtung zum elektrochemischen Strukturieren nach Anspruch 6, wobei das Werkstück (12) und die Elektroden (6, 7) mit einer Dichteinrichtung (19), die dazu ausgelegt ist, die Strukturierungsmuster (14, 14a, 14b) in trockenem Kontakt mit der Rückseite (13) des Werkstück (12) zu halten, in dem Elektrolyt (4) angeordnet sind.

11. Vorrichtung zum elektrochemischen Strukturieren nach einem der Ansprüche 6 bis 10, wobei mindestens eine Arbeitselektrode (7) einen Stromzuführungskopf (7) mit einer strukturierten Oberfläche (14a) aufweist, welche dazu bestimmt ist, mit der Rückseite (13) des Werkstück (12) in ohmschen Kontakt gebracht zu werden, und welche leitende Erhöhungen (16) aufweist, die das zu strukturierende Muster und isolierende Vertiefungen (15) festlegen.

12. Vorrichtung zum elektrochemischen Strukturieren nach Anspruch 11, wobei die Strukturierte Oberfläche (14a) des Stromzuführungskopfes (7) mittels Lithographie in Verbindung mit einem reaktiven Ionenätzen hergestellt ist.

13. Vorrichtung zum elektrochemischen Strukturieren nach einem der Ansprüche 6 bis 12, wobei mindestens eine Arbeitselektrode (7) einen Stromzuführungskopf (7) in ohmschem Kontakt mit einer abnehmbaren Maske (14b) aufweist, welche Strukturierungsmuster mit leitenden Erhöhungen (16) aufweist, die das zu strukturierende Muster und isolierende Vertiefungen (15) festlegen.

14. Vorrichtung zum elektrochemischen Strukturieren nach Anspruch 13, wobei die Maske (14b) ein Werkstück aus gebondetem/gedrehtem Silicium ist, welches derart geätzt ist, dass es die leitenden Erhöhungen (16) aufweist, welche das zu strukturierende Muster und die isolierenden Vertiefungen (15) festlegen.

15. Vorrichtung zum elektrochemischen Strukturieren nach einem der Ansprüche 11 bis 14, wobei die Vertiefungen (15) mit einem isolierenden Material (19) gefüllt sind, welches bündig mit den leitenden Erhöhungen (16) abschließt.

16. Vorrichtung zum elektrochemischen Strukturieren nach den Ansprüchen 10 und 15, wobei das isolierende Material (19) Dichtigkeit gegen das Elektrolyt (4) besitzt.

17. Vorrichtung zum elektrochemischen Strukturieren nach einem der Ansprüche 6 bis 16, wobei der Stromkreis (5) mindestens eine Versorgung aufweist, welche aus einem Galvanostat/Potentiostat (17) besteht.

18. Vorrichtung zum elektrochemischen Strukturieren nach einem der Ansprüche 6 bis 17, wobei eine Gegenelektrode (6) eine Platinelektrode ist, die als Gitterscheibe oder bodenloser Korb ausgeformt ist.

19. Vorrichtung zum elektrochemischen Strukturieren nach einem der Ansprüche 6 bis 18, welche ferner eine Einrichtung (18) zum Rühren des Elektrolyts (4) aufweist.
